# EUROPEAN PATENT APPLICATION

(11) **EP 1 345 266 A1**
(43) Date of publication of application: **17.09.2003**
(21) Application number: 02080124.7
(22) Date of filing: 02.12.2002
(51) Int. Cl.: H01L 23/367

(54) **Heat sink with extended surface area**

(30) Priority: 07.12.2001 SE 1004149
(71) Applicant: Sapa AB, 114 85 Stockholm (SE)
(72) Inventor: Bengtsson, Bo, 612 34 Finspong (SE)

(57) **Abstract**

The present invention is related to a heat sink unit comprising a base (1) and a number of fins extending from the base, said heat sink unit having an extended surface area formed by microfins (2) inserted between the extruded fins. The microfins are formed by folding a strip having a clad braze layer on both sides. The microfins are preferably brazed to the extruded structure by heating the structure after the fins have been inserted to a temperature higher than the melting point of the clad braze.

## Description

The present invention is related to a heat sink unit comprising a base and a number of fins extending from the base, said heat sink unit having an extended surface area formed by microfins inserted between the extruded fins.

The invention is particularly related to the cooling of electronic components.

Semiconductor components such as power ICs are typically housed within a plastic or ceramic package. The packages have leads or surface pads that are brazed to a printed circuit board. The circuit board and package are often located within a chassis, which contains a fan that removes the heat generated by the IC.

It is desirable to have a high rate of heat transfer from the IC package in order to maintain the junction temperatures of the integrated circuit within safe operating limits. Excessive IC junction temperatures may affect the performance of the circuit and cause a permanent degradation of the IC. Power ICs typically have special metallic leads that are to be contacted to external heat sinks. The intention is to conduct the internally generated heat away from the semiconductor to the heat sink and thus keep the temperature of the semiconductor on a low and safe level.

Heat sinks are sometimes mounted to the top surface of the package housing to increase the thermal performance of the package. Conventional heat sinks typically have a number of fins that extend from a bottom base portion. The fins increase the surface area of the heat sink and the heat transfer rate of the package.

When manufacturing heat sinks it is desirable to use a method that is suitable for mass production and economical, and which produces structures that are light-weight and have a high heat conductivity. Extrusion of aluminium is a method that satisfies these criteria.

The miniaturisation of computers puts an increasing demand on computer housings to be kept as small as possible. As a consequence heat sinks that are of small size but with a high capacity for heat dissipation are required. Structures with fins of large height and with short mutual distances are difficult to extrude.

Extruded fin structures are known from GB-2151769 and GB-2079052. In GB-2151769 the distance between the fins are cut in half by inserting one extruded structure into another. In GB-2079052 a fin height to gap ratio of 4:1 is achieved by using alternately short and long fins.

In EP-1028461(Sumitomo Metal Industries, Ltd) a heat sink fin assembly is formed by press forming a thin metal sheet to form a corrugated structure.

In US-6134936 a profile with a ratio between the fin height and the spacing between two adjacent fins of more than 20:1 is described. When increasing the ratio to high numbers the stability of the fins decreases and it becomes increasingly difficult to produce fins that are not deformed. There is also a limit to the amount of heat that may be transferred when the distance between two adjacent fins becomes very small.

It has now been discovered that by inserting a microfin structure between the extruded fins a more efficient transfer of heat is obtained.

Neither of the above documents solves the problem of producing a heat sink of extremely high cooling capacity and stable mechanical properties. There is also no disclosure of a method for producing an extruded heat sink containing microfins between the extruded fins.

### DESCRIPTION OF THE INVENTION

The object of the present invention is to obtain a heat sink unit capable of effectively cooling heat-dissipating objects, such as electronic devices. The electronic device may be any semiconductor component dissipating heat, although power ICs are especially thought of. The object is achieved by forming a heat sink unit with projecting parallel fins extending perpendicularly from the profile base plane and inserting a microfin structure between the fins.

The heat sink profile is preferably extruded to its final shape and there is no need for deformation or machining of the structure.

According to a first embodiment of the invention, the heat sink unit is produced by extruding a billet through an extrusion die and cutting the resulting profile into the desired lengths. A microfin structure is then inserted between the fins of the profile and bonded by a brazing process, e g Controlled Atmosphere Brazing (CAB) or vacuum brazing. The microfins may have alternative structures, e g being louvered, or the folds may be corrugated.

According to a second aspect of the invention one or more cavities are formed in the extruded profile in the side opposite the finned side, and a second heat sink, e g a copper plate, is bonded in the cavity, e g by brazing, shrink fitting or friction welding. Electronic components may then be attached to the copper plate. The copper plate may be omitted and the electronic components attached directly onto the heat sink unit. The cavities may be cut out by for example by milling or may be formed during the extrusion. The area of the cavities is preferably at least half the area of the base plate.

The invention will now be more particularly described, by way of example only, with reference to the accompanying drawings in which:
Figure 1 shows a cross section of the extruded heat sink profile comprising the microfins between the extruded fins.
Figure 2 shows a louvered microfin structure from two different angles.
Figure 3 shows alternative microfin structures.

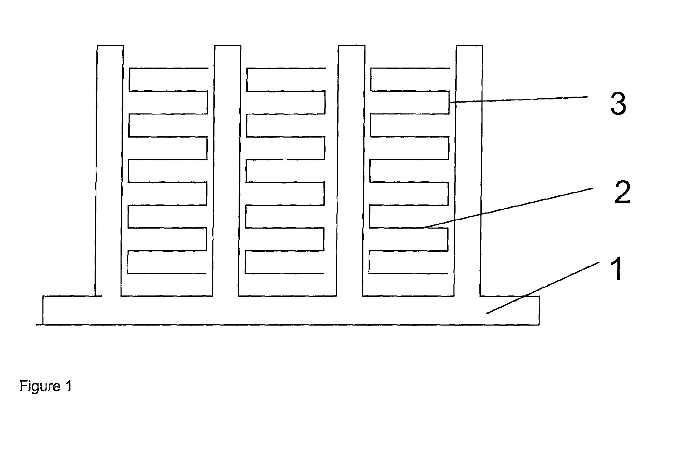

In figure 1 a microfin structure is inserted between the fins (2) of an extruded heat sink. The microfins are formed by folding a thin strip clad with a braze material, so that the bends are more or less 90° according to figure 1 or a rounded bend may be formed. After insertion of the microfins the braze material is melted and forms metallurgical bonds (3) between the microfin and the extruded fins. Other types of bonding may be used as long as an efficient heat transfer between the extruded part and the microfins is obtained.

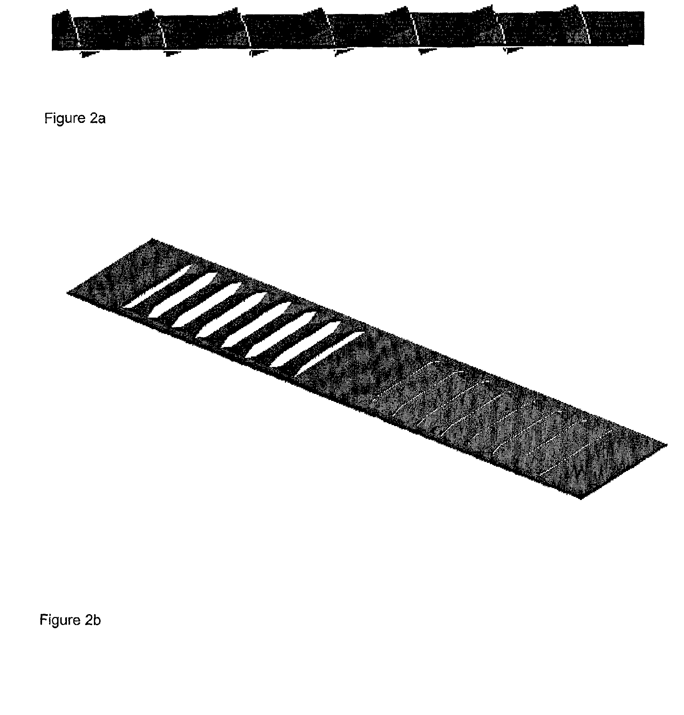

The louvered structure in figure 2 is created by piercing cuts in the strip material. Air may hereby also circulate through the microfins, and not only sidewise.

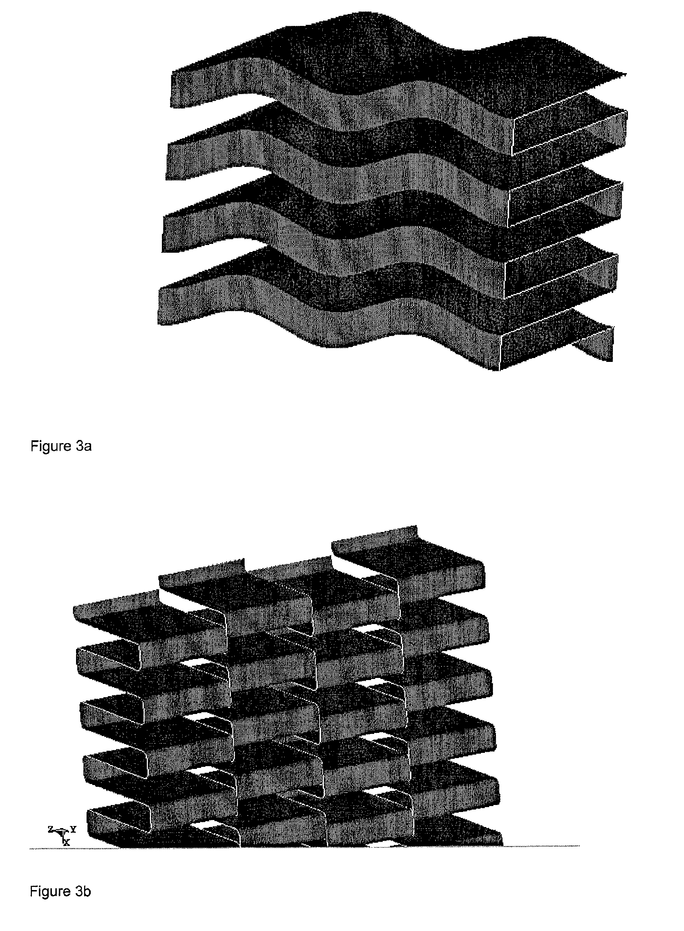

The alternative structures in figure 3 shows different configurations of microfin structures. In figure 3a the fins are corrugated. In figure 3b the microfins are mutually displaced. Other shapes are also possible. To control the flow of air the structures can be combined in the same heat sink, part of the extruded structure may be left without the inserted microfins, all to concentrate the cooling capacity to the hottest spots of the component to be cooled.

The extrusions and the microfins as well as the clad braze layers are preferably made of aluminium, but other materials may also be used.

### Example 1:

An aluminium billet is heated to a temperature suitable for extrusion and the metal is extruded through the die. The material is shaped into a profile comprising a flat base plate (1) with a thickness of 10 mm and a number of fins (2), height 20 mm projecting outwardly from said base plate. The distances between the fins are 10 mm. The profile is cut into lengths of 200 mm. A thin (0,2 mm) rolled aluminium sheet (200 mm wide), being clad with a braze filler metal on each side, is folded to form a 10x5 mm microfin structure, where the distance between the consecutive folds is 3 mm. The strip is brazed onto the fins by heating the structure to 600°C in an oven containing an inert atmosphere and holding for 3 minutes. Cavities are cut in the back of the heat sinks and copper plates are mounted and brazed in the cavities to increase the heat sink capacity. The heat dissipating components are mounted onto the heat sink so that an efficient transfer of the heat generated is obtained. A comparison with an extruded heat sink having the same design as the profile in example 1 and 2, but without the microfin structure, showed that the heat sink according to the invention conducts heat approximately 7 % more efficiently than when no microfins are used.

### Example 2

An extruded aluminium profile is produced as in example 2. A thin (0,3 mm) rolled aluminium sheet (100 mm wide), being clad on both sides with a braze layer is pierced to form 100 consecutive cuts forming a louvred structure (figure 2). The pierced sheet is folded to form a microfin structure, where the distance between the consecutive folds is 2 mm. The strip is brazed onto the fins by heating the structure to 600 °C in an oven in vacuum and holding for 3 minutes.

These examples are by no means limiting, and other forms of microfin structures may be used, e g corrugated structures or the microfin structure may have sections that are mutually diplaced (see figure 3).

## Claims

1. A heat sink unit comprising an extruded structure having a flat base plate (1) and a number of fins (2) projecting outwardly from said base plate, said fins being spaced from each other longitudinally along at least one side of the base, ***characterized in* that** a microfin structure is inserted between at least two of the fins in the extruded structure.

2. A heat sink unit according to claim 1, ***characterized in* that** the inserted microfins structure is metallurgically bonded to the extruded structure.

3. A heat sink unit according to any of claims 1 or 2, ***characterized in* that** the heat sink unit is made of aluminium or an aluminium alloy.

4. A heat sink unit according to any of claims 1-3, ***characterized in* that** the microfin structure is made of aluminium or an aluminium alloy.

5. A heat sink unit according to any of claims 1-4, ***characterized in* that** the microfin structure is clad with a braze material on at least one side.

6. A heat sink unit according to any of claims 1-5, ***characterized in* that** the microfin structure is louvered.

7. A heat sink unit according to claim 1-6, ***characterized in* that** the microfin structure is corrugated.

8. A heat sink unit according to claim 1-7, ***characterized in* that** the microfin structure have sections that are mutually displaced.

9. A heat sink unit according to any of claims 1-8, ***characterized in* that** the base plate has at least one cavity having a second heat sink mounted therein in the side opposite to the side from where the fins extend.

10. A heat sink unit according to any of claims 9-10, ***characterized in* that** at least one electronic component is attached to the second heat sink.

11. A heat sink unit according to claim 11 ***characterized in* that** the electronic component is a power IC.

12. Method of producing a heat sink unit according to claims 1-13, ***characterized in* that**
- an aluminium billet having a raised temperature is extruded through a die to form an aluminium profile having a flat base plate (1) and a number of fins (2) projecting outwardly from said base
- the profile is cut into desired lengths to form the individual heat sink units
- a microfin structure is formed by folding a metal strip
- the microfin structure is inserted between at least two of the extruded fins
- the microfin structure is bonded to the extruded profile.

13. Method of producing a heat sink unit according to claim 12, ***characterized in* that** the microfin structure is clad with a braze material on at least one side and that the step of bonding the microfin structure to the extruded profile indudes
- heating the structure to a temperature higher than the melting point of the braze material
- lowering the temperature to form a heat sink unit of extended surface area.

14. Method of producing a heat sink unit according to any of claims 12 or 13, ***characterized in* that** the microfin structure is formed by aluminium or an aluminium alloy.

15. Method of producing a heat sink unit according to any of claims 12-14, ***characterized in* that** a braze metal layer is clad on both sides of the microfin strip.

16. Method of producing a heat sink unit according to any of claims 12-15, ***characterized in* that** the microfin strip is pierced to obtain a louvred crossection.

17. Method of producing a heat sink unit according to any of claims 12-16, ***characterized in* that** at least one cavity having a second heat sink is mounted therein is formed in the profile in the side opposite the fins during the extrusion.
